# EUROPÄISCHE PATENTSCHRIFT

(11) **EP 1 105 939 B1**
(45) Veröffentlichungstag und Bekanntmachung des Hinweises auf die Patenterteilung: **04.09.2002**
(21) Anmeldenummer: 99938133.8
(22) Anmeldetag: 04.06.1999
(51) Int. Cl.: H01R 9/26

(54) **ANREIHBARE BUSSCHIENE**
MODULAR BUS BAR
BARRES DE BUS JUXTAPOSABLES

(30) Priorität: 25.08.1998 DE 19838493
(43) Veröffentlichungstag der Anmeldung: 13.06.2001
(73) Patentinhaber: R. Stahl Schaltgeräte GmbH, D-74653 Künzelsau (DE)
(72) Erfinder: RAPP, Jürgen, D-74653 Morsbach (DE); SCHRICKEL, Gerhard, D-74676 Niedernhall (DE); KAISER, Manfred, D-74653 Künzelsau (DE)
(74) Vertreter: Patentanwälte Rüger, Barthelt & Abel
(86) Internationale Anmeldenummer: DE9901656
(87) Internationale Veröffentlichungsnummer: WO00013264

(56) Entgegenhaltungen:
- DE-A1- 19 651 961
- DE-C1- 4 013 620
- US-A- 2 980 878
- US-A- 5 486 651
- US-A- 5 655 922

## Beschreibung

Aus der DE-A-44 02 001 ist ein EA-Modul für einen Datenbus bekannt. Der EA-Modul besteht aus einem Gehäuse, das in der Seitenansicht etwa dreieckförmig ist und in Verlängerung der Basisseite einen rechteckförmigen Fortsatz aufweist. An der Basisseite befinden sich Befestigungsmittel, mit denen das Gehäuse auf einer Normhutschiene zu befestigen ist. Der Gehäusefortsatz steht im montierten Zustand seitlich von der Hutschiene weg. In diesem Fortsatz befin-det sich eine Leiterplatte, die einen Abschnitt eines Datenbus darstellt. Außerdem führen von hier Verbindungsleitungen zu der Frontseite des Gehäuses, in der Klemmen zum Drahtanschluss untergebracht sind.

In dem Gehäusefortsatz sind an der Oberseite Kontaktöffnungen enthalten, die einerseits dazu dienen, die jeweiligen Elektronikbausteine mit dem Busgehäuse zu verbinden und andererseits Jumper aufnehmen, um benachbarte Busgehäuse elektrisch miteinander zu verbinden.

Aufgrund dieser Bauart entspricht die Länge jedes Busmoduls der Breite eines einzelnen Gehäuses. Demzufolge ist eine erhebliche Anzahl von Kontaktstellen notwendig, um einen Bus geeigneter Länge zu erzeugen. Dies ist deswegen von Nachteil, weil jede Steckkontaktstelle einen Übergangswiderstand darstellt und gegen Oxidation oder sonstige Verunreinigung empfindlich ist. Verunreinigungen und Oxidation an den Kontaktstellen führen bei den in Feldbussystemen üblichen Strömen und Spannungen zu beträchtlichen Schwierigkeiten. Die große Anzahl von erforderlichen Kontaktstellen erhöht folglich die Störempfindlichkeit.

Nachteilig ist ferner, dass bei dieser Art von Bussystemen keine Lücken gelassen werden können.

Schließlich ist der Platzbedarf dieser bekannten Lösung enorm, zumal der Raum in der Hutschiene nicht ausgenutzt wird.

Ausgehend hiervon ist es Aufgabe der Erfindung, eine anreihbare Busschiene zu schaffen, die einen geringen Raumbedarf hat und weniger störempfindlich ist.

Diese Aufgabe wird erfindungsgemäß mit der Busschiene nach Anspruch 1 gelöst.

Die neue anreihbare Busschiene weist ein längliches rohrförmiges Gehäuse auf, das an beiden Stirnenden derart gestaltet ist, dass eine weitere gleich aufgebaute Busschiene mechanisch und elektrisch ansteckbar ist. In der Vorderseite des Gehäuses sind mehrere Öffnungen vorhanden, durch die hindurch Steckverbinder, vorzugsweise Steckbuchsenleisten zugänglich sind, um entsprechende elektronische Geräte mit dem Bus zu verbinden.

Da eine anreihbare Busschiene mit mehreren, vorzugsweise bis zu acht Öffnungen versehen ist, treten bei der Verlängerung frühestens nach acht Geräten Kontaktstellen auf, um die Busschiene mit einer weiteren Busschiene zu verbinden.

Eine sehr einfache Gehäusekonstruktion ergibt sich, wenn das eine Gehäuseteil ein U-förmiges Querschnittsprofil mit zwei zueinander parallelen, voneinander beabstandeten Schenkeln und ein Rückenteil aufweist, das sich zwischen diesen Schenkeln erstreckt. Am fertigen Gehäuse bilden die Schenkel praktisch die gesamte Schmalseite, während das Rückenteil die Vorderseite des Gehäuses darstellt. Hierdurch entsteht auf der gegenüberliegenden Seite eine Gehäuseöffnung, die sich über die gesamte Breite und Länge erstreckt, so dass ohne weiteres Leiterplatten eingelegt werden können. Insbesondere ist es dadurch möglich, die an den Leiterplatten sitzenden Steckverbinderleisten, die durch die Öffnungen zugänglich sind, erhöht anzubringen, damit sie durch die Öffnungen in der Vorderseite hindurchragen. Hierdurch wird gleichzeitig die Leiterplatte in Längsrichtung innerhalb des Gehäuses festgesetzt.

Um beim Einsetzen des Gehäuses, z.B. in eine Normhutschiene, eine definierte Anlage zu bekommen, sind neben der Vorderseite des Gehäuses zwei in Längsrichtung durchlaufende Leisten angeformt, deren Außenseite mit der Vorderseite bündig ist.

Um eine glatte Außenkontur und eine sichere Halterung des zweiten oder Rückteils des Gehäuses zu bekommen, sind die Schenkel des U-förmigen Querschnittprofils mit schmalen leistenförmigen Fortsätzen versehen.

Das Rückenteil ist eine im Wesentlichen ebene Platte, die seitlich parallel mit Abstand zueinander verlaufenden Nuten zur Aufnahme der leistenförmigen Fortsätze des ersten Gehäuseteils enthält. Damit die Rückseite nicht mit eventuellen Befestigungsschrauben der Hutschiene kollidiert, springt sie gegenüber den Schmalseiten des Gehäuses geringfügig zurück.

Um beim Ansetzen einer Elektronikbaugruppe an die verlängerbare Hutschiene die Kontaktstifte zu schützen, ist jede an der Vorderseite des Gehäuses vorhandene Öffnung von einem Kragen umgeben. Dadurch werden jene Teile der Kontaktstifte geschützt, die freiliegen, nachdem bereits der erste elektrische Kontakt hergestellt ist, jedoch bevor die Kontaktstifte vollständig eingeschoben sind. Außerdem führen diese Krägen sehr gut seitlich die Steckverbinderleisten und fixieren so die Leiterplatte in Längsrichtung.

Ein weiterer Zweck der Krägen besteht darin, ein exakt gerades Aufstecken der Elektronikbaugruppen zu erzwingen. Ein verkantetes oder schiefes Aufstecken könnte die feinen Steckerstifte beschädigen.

Um beim Zusammenstecken der Busschienen eine mechanisch gute Verbindung zwischen den Gehäusen zu bekommen und andererseits die blank liegenden Abschnitte der Steckerstifte nach außen hin zu schützen, sind an den beiden Stirnenden der Gehäuse Krägen vorhanden, die beim Zusammenstecken wechselseitig ineinandergreifen. Dadurch wird bereits beim Zusammenstecken ein Berührungsschutz gemäß IP 30 erreicht, d. h. die weitere Busschiene kann unter Spannung an eine bereits installierte und mit Verbrauchern bestückte Busschiene angesteckt werden, und zwar auch in einem explosionsgefährdeten Bereich.

Der Kragen an einem Stirnende kann ein in Umfangsrichtung praktisch geschlossener Kragen sein, während der Kragen an dem anderen Stirnende aus plattenförmigen Abschnitten zusammengesetzt ist, wobei an jeder Ecke Schlitze enthalten sind. Dadurch können beim Zusammenstecken beispielsweise die Fortsätze der Vorderseite und der Rückseite in den anderen Kragen eingreifen, während die Fortsätze der Schmalseite von außen über den anderen Kragen übergreifen. Am Ende ergibt sich eine praktisch glatte rohrförmige Verlängerung der Gehäuse im Bereich der zusammengesteckten Stirnenden.

Da es beim Aufbau der Leiterplatte und dem Anbringen der Steckverbinderleisten an den Stirnenden zu unvermeidbaren Toleranzen kommt, müssen diese so angebracht werden, dass sie beim Zusammenstecken der Gehäuse nicht sperren. Dies bedeutet umgekehrt immer ein kleines Stück bei jedem Steckerstift, das an sich blankliegt. Durch die rohrförmig ineinander steckenden Krägen werden diese Abschnitte gegen Einbringen von Fremdkörpern und damit auch Kurzschluss geschützt.

Die Abmessungen des Gehäuses sind so gewählt, dass es ohne weiteres in die Nut einer Normhutschiene einlegbar ist. Dadurch kann der Raum in der Hutschiene für die Busverbindungen ausgenutzt werden, was einer Miniaturisierung und Verringerung des Platzbedarfes wesentlich entgegenkommt. Außerdem bildet die Hutschiene gleichzeitig einen sehr stabilen Schutz gegen mechanische Beschädigung des Gehäuses und sie ist in der Lage, stabil die aufgesetzten Elektronikbauteile zu haltern. Die Befestigungskraft zum Halten der Bauteile kommt von der Hutschiene und braucht von dem Gehäuse nicht übertragen zu werden. Das Gehäuse kann deswegen aus verhältnismäßig dünnwandigem Isolier-stoff hergestellt sein.

Bei aufgesetzten Elektronikbaugruppen wird die Busschiene automatisch in der Hutschiene festgehalten. Damit sie vor dem Einsetzen nicht herausfällt, sind eine oder mehrere Halteklammern vorgesehen, die die Ränder der Hutschiene umgreifen. Die Halteklammern haben eine U-förmige Gestalt mit einem Rückenteil und zwei seitlichen Schenkeln.

Das Rückenteil ist mit einer rechteckigen Ausnehmung versehen, durch die der Kragen hindurchpasst, der die Öffnung an der Frontseite umgibt. Auf diese Weise wird die Halteklammer relativ zu dem Gehäuse in Längsrichtung festgelegt.

In der Zeichnung sind Ausführungsbeispiele des Gegenstandes der Erfindung dargestellt. Es zeigen:
Fig. 1 einen Abschnitt der erfindungsgemäßen Busschiene mit einer Ansicht auf das Stirnende mit den Steckerstiften, in einer perspektivischen Darstellung,
Fig. 2 den Abschnitt der Busschiene nach Fig. 1, teilweise aufgebrochen, in derselben Darstellungsform,
Fig. 3 das andere Stirnende der erfindungsgemäßen Busschiene, in einer perspektivischen Darstellung,
Fig. 4 die Halteklammer zum Sichern des Gehäuses in einer Normhutschiene, in einer perspektivischen Darstellung und
Fig. 5 einen Abschnitt der Busschiene nach Fig. 1, in einem Längsschnitt.

Die Figuren zeigen in einer vereinfachten perspektivischen Darstellung eine modulare Busschiene 1 zusammen mit einer darunter gezeichneten Normhutschiene 2.

Bei der Normhutschiene 2 handelt es sich um ein längliches Blechformteil, das über die Länge konstante Abmessungen und Gestalt aufweist. Es ist derart gebogen, dass seitlich zwei in einer gemeinsamen Ebene liegende Halteflansche 3 und 4 entstehen, die an zueinander parallelen Außenkanten 5 und 6 enden. Beide Flansche 3 und 4 haben dieselbe Breite und gehen an zueinander parallelen Biegekanten 7 und 8 in eine rechteckige Nut 9 über, die von zwei zueinander parallelen Seitenwänden 11, 12 sowie einem Boden 13 begrenzt ist.

Die Hutschiene 2 ist in den Figuren abgebrochen veranschaulicht.

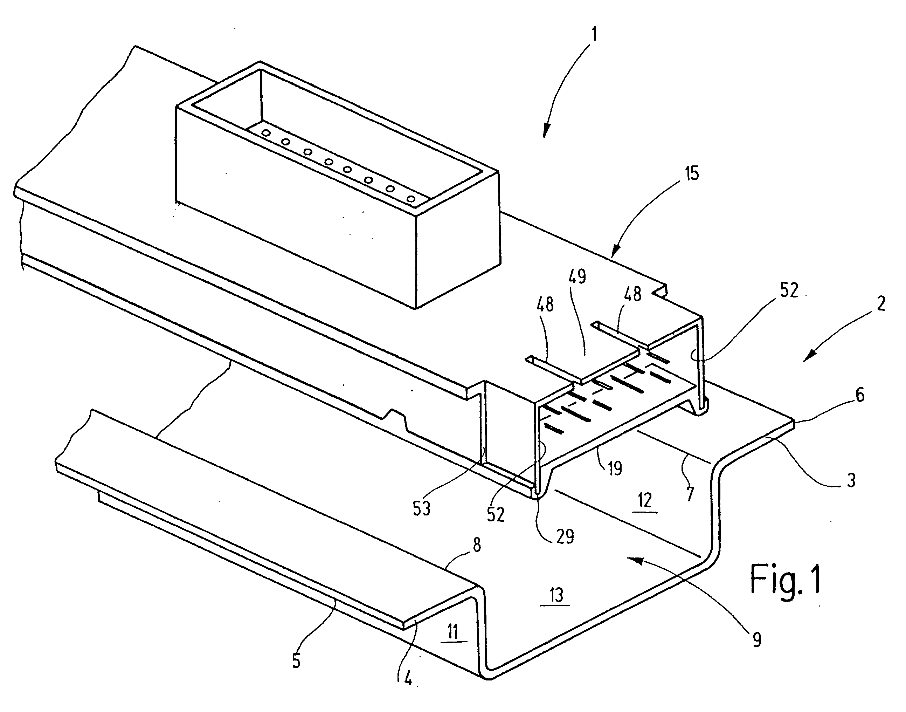

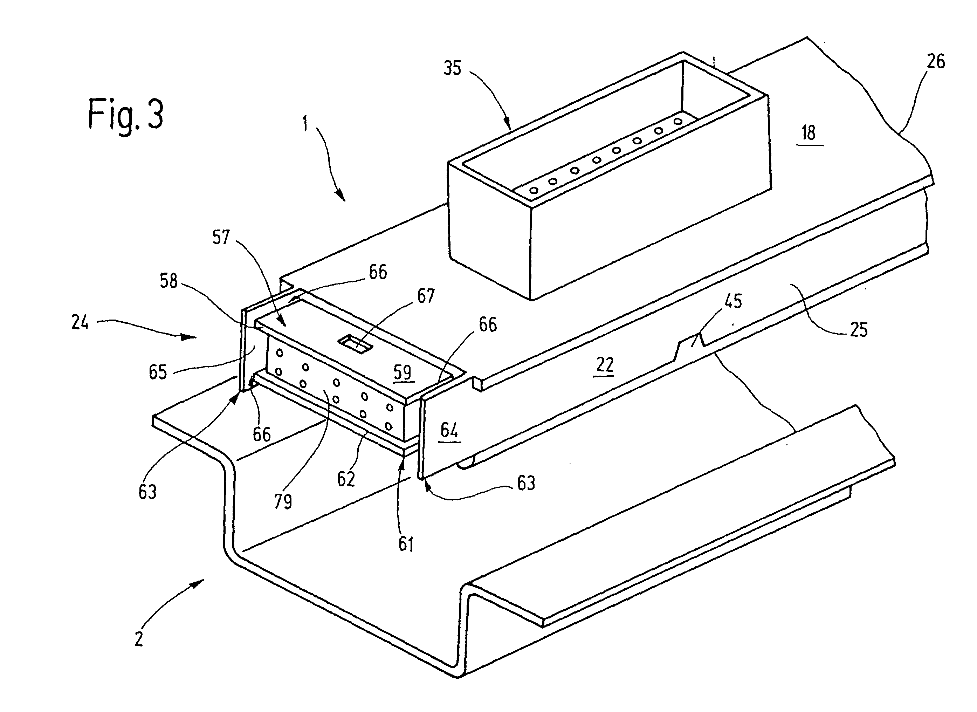

Die darüber gezeigte Busschiene 1 ist zur Montage in der Nut 9 der Busschiene 1 vorgesehen. Die Busschiene 1 ist ebenfalls abgebrochen wiedergegeben, wobei in den Fig. 1 und 3 die beiden sich voneinander unterscheidenden Stirnenden gezeigt sind.

Zu der Busschiene 1 gehört ein längliches, rohrförmiges Gehäuse 15, das aus einem oberen Gehäuseteil 16 und einem unteren Gehäuseteil 17 besteht. Beide Gehäuseteile 16, 17 bestehen aus Isolierstoff. Das Gehäuse 15 weist eine Vorder- oder Frontseite 18, eine dazu parallele Rückseite 19 sowie zwei parallel mit Abstand zueinander verlaufende Schmalseiten 21 und 22 auf. In Längsrichtung gesehen endet es an einem Stirnende 23 sowie einem Stirnende 24. Die beiden Stirnenden 23 und 24 unterscheiden sich und sind so gestaltet, dass sie zusammengesteckt werden können.

Das obere Gehäuseteil 16 hat eine über die Länge im Wesentlichen konstante U-förmige Querschnittsgestalt, die sich aus zwei parallel mit Abstand zueinander verlaufenden seitlichen Schenkeln 25 und einem Rückenteil 26 zusammensetzt. Die beiden Schenkel 25 haben zueinander spiegelbildliche Gestalt und werden von einer Innenseite 27 sowie einer Außenseite 28 begrenzt, wobei die Außenseite 28 gleichzeitig den überwiegenden Teil der Schmalseite 22 des Gehäuses 15 bildet. An dem von dem Rückenteil 26 abliegenden Ende gehen die beiden Schenkel 25 in schmale leistenförmige Fortsätze 29 über. Die Dicke der schmalen Leiste 29 entspricht der halben Dicke, gemessen zwischen den beiden Wandflächen 27 und 28, und sie ist so angeordnet, dass die Innenwand 27 über die Leiste 29 glatt durchgeht.

Der Rücken 26 ist eine im Wesentlichen ebene Platte, der von einer Innenseite 31 sowie einer Außenseite 32 begrenzt ist, wobei die Außenseite 32 gleichzeitig auch die Fronstseite 18 des Gehäuses 15 ist.

An der Übergangsstelle zwischen den Schenkeln 25 in den Rücken 26 ist das Gehäuseoberteil 16 mit zwei seitlichen Leisten 33 und 34 versehen, deren Oberseite glatt in die Fläche 32 des Rückens 26 übergeht.

Auf dem Rücken 26 sind ferner mehrere, im Querschnitt rechteckige Krägen 35 einstückig angeformt, die von der Frontseite 18 rechtwinklig wegstehen und eine ebenfalls rechteckige Durchgangsöffnung 36 umgrenzen, die bis in das Innere des Gehäuses 15 führt.

Das Gehäuseunterteil 17 ist eine längliche weitgehend ebene Platte 37 mit einer ebenen Ober- oder Innenseite 38 und einer dazu parallelen Außenseite, die die Rückseite 19 bildet. An den seitlichen Rändern der Platte 37 sind nach unten ragende leistenförmige Fortsätze 39 und 41 vorgesehen.

Der Fortsatz 39 bildet eine nach außen weisende ebene Fläche 42, die rechtwinklig zu der Innenseite 38 verläuft. Sie geht an ihrem unteren Ende glatt in die Seitenwand einer nach oben offenen Nut 43 über, die in dem Fortsatz 39 ausgebildet ist. Die andere Wand der Nut 43 wird von einer Leiste 44 gebildet, deren Höhe deutlich niedriger ist als die des Fortsatzes 39, so dass die Leiste 44 unterhalb des Niveaus der Rückseite 19 endet. Der Querschnitt der Nut 43 entspricht den Abmessungen der schmalen Leiste 29, die bei zusammengesetztem Gehäuse in diese Nut 43 eintaucht, wobei die Innenseite 27 der Schenkel 25 an der Fläche 42 anliegt.

Der Fortsatz 41 ist in der gleichen Weise gestaltet, so dass die soeben gegebene Beschreibung in spiegelbildlicher Weise gilt.

Fig. 1 lässt erkennen, wie die leistenförmigen Fortsätze 29 in die beiden Nuten 43 eingesteckt sind und die Innenseite 27 der Schenkel 25 an den Seitenflächen 42 anliegen.

Es ist ferner zu erkennen, dass aufgrund der Abmessungen der Leiste 44 die Schmalseite 22 eine glatte durchgehende Fläche bildet, die sich aus der Außenseite der Leiste 44 und der Außenseite 28 des Schenkels 25 zusammensetzt.

Damit das Gehäuseoberteil 16 gegenüber dem Gehäuseunterteil 17 in Längsrichtung verriegelt ist, trägt die schmale Leiste 44 auf ihrer nach oben zeigenden Fläche im Abstand voneinander mehrere trapezförmige Zähne 45, die in entsprechende komplementäre Ausnehmungen im Bereich der Außenseite 28 des Schenkels 25 eingreifen, wie dies ebenfalls Fig. 1 erkennen lässt.

Das Stirnende 23 besteht aus einem im Querschnitt im Wesentlichen rechteckigen Kragen 46, der den in dieser Richtung an sich offenen Innenraum des Gehäuses 16 umgrenzt. Der Kragen 46 besteht an der Oberseite aus einer plattenförmigen Verlängerung des Rückens 26 des Gehäuseoberteils 16. Diese plattenförmige Verlängerung 47 ist an ihrer Außen- oder Oberseite mit der Außenseite 32 bündig. Ihre Innenseite springt gegenüber der Innenseite 31 um die halbe Stärke des Rückens 26 zurück.

In der plattenförmigen Verlängerung 47 sind zwei einends offene Schlitze 48 enthalten, die zwischen sich eine Federzunge 49 begrenzen. Die Federzunge 49 trägt auf der Unterseite eine Rastnase 51.

Die seitlichen Wände des Kragens 46 sind plattenförmige Verlängerungen 52 der Schenkel 25. Ihre axiale Länge entspricht der axialen Länge der plattenförmigen Verlängerung 47.

Die plattenförmigen Verlängerungen 42 gehen in den Eckbereichen einstückig in die obere plattenförmige Verlängerung 47 und außerdem über einen Rücksprung 53 in die Außenseite 28 der Schenkel 25 über. Die Wandstärke der plattenförmigen Verlängerung 52 entspricht der Dicke der Leiste 29.

Die untere Wand des Kragens 46 bildet schließlich eine ebene Rücksprungfläche 55, die in der Oberseite 38 des unteren Gehäuseteils 17 ausgebildet ist. Die auf diese Weise von dem Kragen 46 begrenzte rohrförmige rechteckige Öffnung hat eine lichte Weite, gemessen in Querrichtung, gleich der lichten Weite des von dem Gehäuseoberteil 15 umgrenzten Innenraums, während die Abmessungen quer dazu jeweils um zweimal die halbe Wandstärke größer sind als der Querschnitt des besagten Innenraums.

Der Kragen 46 an dem Stirnende 23 stellt eine gerade einstückige Verlängerung des Gehäuses 15 dar.

Das Stirnende 24 des Gehäuses 15, das dem Stirnende 23 diametral gegenüberliegt, hat eine Gestalt, so dass es mit dem Stirnende 23 zusammensteckbar ist.

Zu dem Stirnende 24 gehört ein plattenförmiger Fortsatz 57 des Rückens 26. Der plattenförmige Fortsatz 57 endet an einer geraden Kante 58 und er ist so gestaltet, dass seine Unterseite glatt in die Unterseite 31 des Rückens 26 übergeht, während seine Außen- oder Oberseite 59 gegenüber der Oberseite 32 um die Stärke des plattenförmigen Fortsatzes 47 des anderen Stirnendes 23 zurückspringt.

Ein zu dem plattenförmigen Fortsatz 57 parallel beabstandeter weiterer plattenförmiger Fortsatz 61 ist an dem Gehäuseunterteil 17 ausgebildet und er endet an einer Stirnkante 62. Die Stärke des plattenförmigen unteren Fortsatzes 61 entspricht im Wesentlichen dem durch die Rücksprungfläche 55 definierten Rücksprung.

In Querrichtung gesehen haben die beiden plattenförmigen Fortsätze 57 und 61 eine Länge entsprechend der lichten Weite in dem Kragen 46, gemessen in derselben Richtung.

Jeder der beiden seitlichen Schenkel 25 des U-förmigen Profils 26 ist ebenfalls mit einem plattenförmigen Fortsatz 62 versehen. Der plattenförmige Fortsatz 62 geht auf seiner Außenseite 63 glatt in die Außenseite 28 über. Die Innenseite 64 dagegen springt gegenüber der Wandfläche 27 zurück, so dass die Stärke des plattenförmigen Fortsatzes 62 etwa halb so groß ist wie die Stärke des Schenkels 25 im Bereich zwischen den beiden Stirnenden 23 und 24.

Die Höhe der plattenförmigen Fortsätze 62 entspricht im Wesentlichen dem Abstand zwischen der Oberseite 18 und der Oberkante der Leiste 44, 17.

Aufgrund dieser Geometrie entstehen insgesamt vier Schlitze 66, und zwar zwei Schlitze 66 zwischen den seitlichen Fortsätzen 62 und dem oberen plattenförmigen Fortsatz 59 sowie zwei weitere Schlitze 66 zwischen den seitlichen Kanten des unteren plattenförmigen Fortsatzes 61 und der Innenseite der plattenförmigen Fortsätze 63. Die Weite der Schlitze 66 entspricht der Wandstärke der plattenförmigen Fortsätze 52 an dem Stirnende 46.

Sämtliche plattenförmige Fortsätze 59, 61 und 63 haben in axialer Richtung gesehen dieselbe Länge, so dass ihre Stirnkanten 58, 62 in derselben Ebene liegen.

Schließlich enthält der obere plattenförmige Fortsatz 57 eine Rastöffnung 67, die im zusammengesteckten Zustand mit der Rastnase 51 fluchtet.

Im Inneren des Gehäuses 15 erstreckt sich parallel zu der Vorderseite 18 eine längliche Leiterplatte 71 mit darauf befindlichen Leiterbahnen 72. Die Breite der Leiterplatte 71 entspricht dem Abstand der Seitenwände 27 voneinander, während ihre Länge gleich dem Gehäuse 15 zuzüglich der Tiefe einer der beiden Stirnenden 23, 24 ist. Die Leiterplatte 71 wird im Inneren des Gehäuses 15 durch in den Figuren nicht erkennbare Distanzrippen fixiert, die an der Innenwand 27 angeformt sind und bis zu der Oberseite der Leiterplatte 71 reichen. An einem Ausweichen der Leiterplatte 71 nach unten wird diese durch Auflage auf der Innenfläche 38 gehindert.

In die Leiterplatte 71 sind pro Öffnung 36 eine Steckbuchsenleiste 73 mit ihren Lötfahnen 74 eingelötet. Sie sind so angeordnet, dass ihre Oberseite 75 sich oberhalb des Rückens 26 befindet, d.h. ihr Grundkörper 76 reicht bis in die durch den Kragen 35 umgrenzte Öffnung 36 hinein. Die Einsteckrichtung steht auf der Leiterplatte 71 senkrecht.

Die Öffnung 36 hat solche Abmessungen, dass der Grundkörper 76 mit geringem Spiel darin aufgenommen ist.

An demjenigen Ende, das dem Stirnende 23 benachbart ist, trägt die Leiterplatte 71 eine Steckerleiste 77, die so aufgelötet ist, dass ihre Steckerstifte 78 parallel zu der Längserstreckung des Gehäuses 15 liegen. Die Tiefe des Kragens 46 ist gegenüber den Steckerstiften 78 so bemessen, dass diese gegenüber dem freien Stirnende des Kragens 46 ein kurzes Stück, ca. 1,5 mm, zurückspringen.

An dem gegenüberliegenden Ende ist die Leiterplatte 71 mit einer komplementären Steckbuchsenleiste 79 versehen, deren Stirnseite fast mit den Stirnkanten 58, 62 der plattenförmigen Fortsätze 57, 61, 63 des Stirnendes 24 bündig ist.

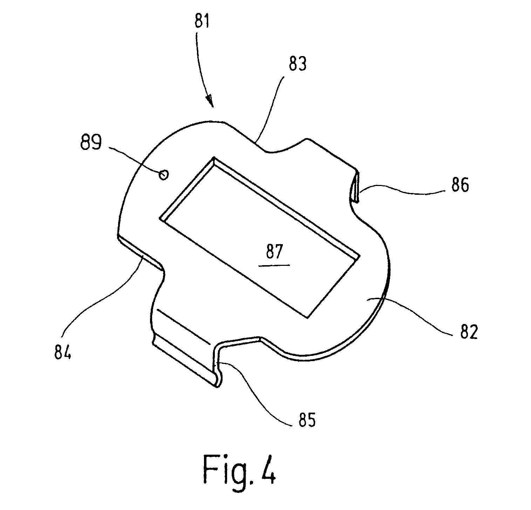

Um die Busschiene 1 in der Hutschiene 2 festzuhalten, sind in Fig. 4 gezeigte Halteklammern 81 vorgesehen.

Die Halteklammer 81 ist ein beispielsweise aus Bronze gefertigtes Blechformteil mit einem scheiben- oder plattenförmigen Rücken 82, an dessen seitliche Kanten 83 und 84 nach unten weisende Federschenkel 85 und 86 angeformt und abgebogen sind. Der Abstand zwischen den beiden Federschenkeln 85 und 86 entspricht dem Abstand der Kanten 5 und 6 an der Hutschiene 2.

Um ein Verschieben in Längsrichtung der Halteklammer 81 gegenüber dem Gehäuse 15 zu verhindern, enthält der plattenförmige Rücken 82 eine rechteckige Öffnung 87, deren Abmessungen mit den Außenabmessungen der Krägen 35 übereinstimmt.

Die Montage und Handhabung ist wie folgt:

Zur Fertigung der Busschiene 1 werden auf einer entsprechend vorbereiteten Leiterplatte 71 endseitig die beiden Steckverbinderleisten 77 und 79 aufgelötet. Die Steckerstifte 78 zeigen parallel zu der Oberseite der Leiterplatte 71 und in deren Längsrichtung. Gleiches gilt für die Achsen der Steckbuchsen in der Steckbuchsenleiste 79.

Ferner werden die Steckbuchsenleisten 73 auf die Oberseite der Leiterplatte 71 aufgesteckt und mit den Leiterbahnen verlötet. Die Achsen der Steckbuchsen dieser Steckbuchsenleisten 73 stehen senkrecht auf der durch die Leiterplatte 71 definierten Ebene.

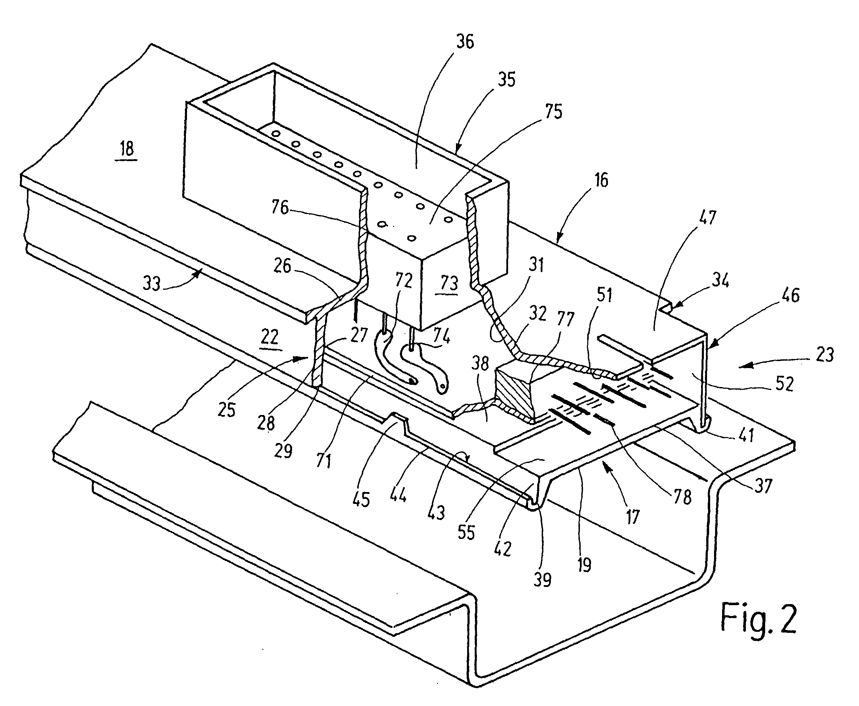

Die so vorbereitete Leiterplatte 71, die mit einer Steckerleiste 77, einer Steckbuchsenleiste 79 und mehreren Steckbuchsenleisten 73 bestückt ist, wird in das Gehäuseoberteil 16 eingelegt. In der Endlage kommen die Steckbuchsenleisten 73 in den zugehörigen Öffnungen 36 zu liegen, wie dies die aufgebrochene Darstellung von Fig. 2 erkennen lässt. In dieser Stellung liegt die Oberseite der Leiterplatten 71 gegen die nicht erkennbaren Stirnenden von Leisten an, die an der Innenwand 27 ausgebildet sind und Distanzstücke bilden, um die Leiterplatte 71 im richtigen Abstand zu der Innenseite des Rückens 26 zu fixieren.

Sodann wird das Gehäuseunterteil mit der Innenseite 38 voraus zwischen die Schenkel 25 eingelegt und angedrückt. Dabei dringen die trapezartigen Zähne 45 in die zugehörigen trapezförmigen Ausnehmungen ein und außerdem gelangen die leistenförmigen Fortsätze 29 in die dazu vorgesehenen Nuten 43. Ein Auseinanderfallen der beiden Gehäuseteile 16 und 17 wird dadurch verhindert, dass die leistenförmigen Fortsätze 29 geringfügig wulstartig bombiert sind, während die zugehörigen Nuten 43 nicht exakt parallelflankig sind, sondern im Bereich des Nutenschlitzes einen geringfügigen Rücksprung enthalten, wodurch sich eine Verrastung ergibt.

Die Leiterplatte 71 ist im montierten Zustand zwischen den oben erwähnten Distanzleisten und der Innenseite 38 des Gehäuseunterteils 17 mit geringem vertikalen Spiel fixiert. Die Lötfahnen der einzelnen Bauteile schauen auf der Unterseite der Leiterplatte 71 hervor und stehen auf der Innenseite 38 auf.

Die Busschiene 1 ist somit fertig montiert und kann in der Nut 9 einer Hutschiene 2 verlegt werden.

Wenn mehr Anschlüsse in Gestalt der Steckbuchsenleisten 73 benötigt werden als eine einzige Busschiene 1 aufweist, kann eine weitere Busschiene 1 mit gleicher Geometrie an dem Stirnende 23 oder an dem Stirnende 24 angesteckt werden. Beim Zusammenstecken der beiden Stirnenden 23 und 24 dringen die Steckerstifte 78 des Stirnendes 23 in die Buchsen der Steckbuchsenleiste 79 ein. Gleichzeitig dringen auch die beiden plattenförmigen Fortsätze 57 und 61 in den durch den Kragen 56 begrenzten rechteckigen rohrförmigen Innenraum ein, während die seitlichen plattenförmigen Fortsätze 63 den Kragen 46 seitlich außen übergreifen. Im vollständig zusammengesteckten Zustand gehen die Schmalseiten 22 beider Busschienen 1 glatt und ohne Sprünge im Bereiche der plattenförmigen Fortsätze 64 ineinander über. Die beiden Busschienen 1 gehen auch im Bereich der Vorderseite 18 und im Bereich der Rückseite 17 glatt und ohne Sprung ineinander über. Da die Gehäuse der beiden Busschienen 1 sowohl über die Steckerstifte 78 als auch über den Kragen 46 sowie die plattenförmigen Fortsätze 57, 61, 63 miteinander verbunden sind, ergibt sich eine leicht zu handhabende Einheit, die an der Verbindungsstelle verhältnismäßig unempfindlich ist.

Nach dem Zusammenstecken der entsprechenden Zahl von Busschienen 1 wird die so erhaltene Gesamteinheit in der Nut 9 der Busschiene 1 plaziert. Anschließend werden mehrere der Halteklammern 81 in Abständen über die Krägen 35 gestülpt, soweit, bis ihre seitlichen Federschenkel 85 und 86 hinter dem Rand der seitlichen Flansche 3 und 4 der Hutschiene 2 verrasten. Die Halteklammern 81 drücken die Unterseiten der seitlichen Anlageleisten 33 und 34 gegen die Oberseite der Flansche 3 und 4. In dieser Stellung steht außerdem das Gehäuseunterteil 17 mit den beiden seitlichen wulstartigen Fortsätzen 41 auf dem Boden 13 auf. Damit die Federklammern 81 das Aufsetzen von Gerätegehäusen nicht beeinträchtigen, können um die Krägen 35 herum Vertiefungen vorgesehen sein, die der Gestalt des plattenförmigen Rückens 82 entsprechen.

Auf die so vorbereitete Hutschiene 2 können nun Elektronikbaugruppen, die üblicherweise in Gehäusen enthalten sind, aufgesteckt und mit der Hutschiene 2 verrastet werden. Die Krägen 35 erzwingen dabei eine unverkantete gerade Aufsteckbewegung, was eine Beschädigung der feinen Kontaktstifte verhindert und es außerdem erleichtert, dass die Kontaktstifte in die zugehörigen Buchsenlöcher finden.

Weil die unteren Kanten der Schmalseiten 22 auf dem Boden 13 aufstehen wird die beim Einstecken der Bauteile auftretenden Kraft von der Leiterplatte 71 über die Innenseite 38 und die leistenförmigen Fortsätze 39, 41 direkt in den Boden 13 der Hutschiene 2 eingeleitet. In dem Gehäuse 15 entsteht keine Sprengkraft im Sinne des Trennens der beiden Gehäuseteile 16, 17.

Da die Breite der Busschiene, gemessen an den Außenseiten der Schmalseite 22, gleich dem lichten Abstand zwischen den Seitenwänden 11 und 12 ist, wird die Busschiene 1 in der Hutschiene 2 weitgehend spielfrei festgehalten.

Ein wesentlicher Vorteil der Unterbringung der Busschiene in der Hutschiene besteht darin, dass die aus Metall bestehende Hutschiene gleichzeitig als Abschirmung gegen Störstrahlung dienen kann, die sonst in die Leiterbahnen der Busschiene eingekoppelt werden könnte.

Eine noch bessere Abschirmung erhält man, wenn zusätzlich die Leiterplatte 71 mit einem flächigen Masseleiter versehen ist, der obendrein elektrisch mit der Hutschiene 2 in Verbindung steht. Hierzu kann die Halteklammer 81 verwendet werden. Sie enthält eine Bohrung 89, die im montierten Zustand mit einer Bohrung 91 fluchtet, die in der Oberseite 18 des oberen Gehäuseteils 16 ausgebildet ist. Diese Bohrung 91 setzt sich durch einen zylindrischen Fortsatz 92 fort, der an der Unterseite 31 einstückig angeformt ist. Die Länge des zylindrischen Fortsatzes 92, der als Distanzstück dient, entspricht dem Abstand der Leiterplatte 71 von der Unterseite 31.

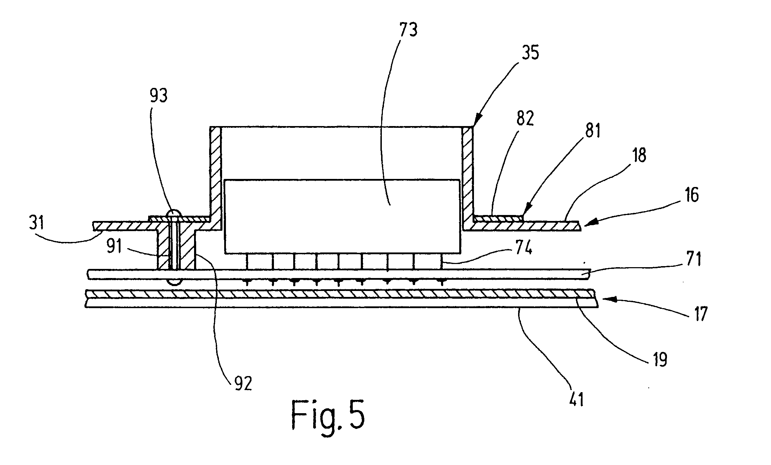

Durch die miteinander fluchtenden Bohrungen 89 und 91 führt ein elektrisch leitender Niet 93 hindurch, der an der Rückseite der Leiterplatte 91 vernietet ist, wie dies Fig. 5 erkennen lässt.

Gegenüber dem zuvor erläuterten Ausführungsbeispiel ist bei dieser Ausführungsform die Montage sinngemäß geändert. Nach dem Einsetzen der Leiterplatte 71 in das obere Gehäuseteil 16 wird die Halteklammer 81 über den betreffenden Kragen 35 gestülpt und mit Hilfe des Niets 93 elektrisch leitend mit der Masseleitung oder Abschirmungsleitung der Leiterplatte 71 vernietet. Auf diese Weise entsteht eine elektrisch leitende Verbindung zwischen der Halteklammer 81 und der Leiterplatte 71. Sodann wird das zweite Gehäuseteil 17 aufgeschnappt, womit die Busschiene 1 fertig montiert ist.

Eine Busschiene weist ein längliches bzw. quaderförmiges, aus Isolierstoff bestehendes Gehäuse auf, in dem eine über die Länge des Gehäuses durchgehende Leiterplatte untergebracht ist. An einem Ende ist die Leiterplatte mit einer Buchsenleiste und am anderen Ende mit einer Steckerleiste versehen. Außerdem trägt sie mehrere Steckverbinderleisten, deren Buchsen bzw. Steckerstifte auf der Leiterplatte senkrecht stehen.

Das längliche Gehäuse ist an beiden Stirnenden so konfiguriert, dass an jedem Stirnende eine weitere Busschiene ansteckbar ist, so dass sich eine mechanische und elektrische Verbindung zwischen den Busschienen ergibt. Die Außenabmessungen des Gehäuses entsprechen der in der Busschiene enthaltenen Nut, damit die Busschiene in der Hutschiene verlegt werden kann.

## Patentansprüche

1. Anreihbare Busschiene (1)
mit einem länglichen Gehäuse (15), das eine Öffnungen (36) enthaltende Vorderseite (18), eine dazu parallele Rückseite (19), zwei Schmalseiten (22) sowie zwei offene Stirnenden (23,24) aufweist, das einen rohrförmigen Innenraum begrenzt und zu dem ein erstes und ein zweites längliches Gehäuseteil (16,17) gehören, die miteinander verbunden sind, wobei die Stirnenden (23,24) zueinander komplementär gestaltet sind, derart, dass an jedes Stirnende (23, 24) das komplementäre Stirnende (23,24) einer gleich gestalteten anreihbaren Busschiene (2) ansteckbar ist,
mit einer in dem Innenraum angeordneten länglichen Leiterplatte (71) mit darauf angeordneten Leiterbahnen (72), die zwei Flachseiten sowie zwei Stirnenden aufweist und deren Breite so bemessen ist, dass sie in dem länglichen Innenraum unterzubringen ist,
mit Steckverbinderleisten (73), die auf der einen Flachseite der Leiterplatte (71) angeordnet sind, die mit den Leiterbahnen (72) elektrisch leitend verbunden sind und von denen jede mit einer zugehörigen Öffnung (36) in der Vorderseite (18) des Gehäuses (15) fluchtet,
mit einer Steckbuchsenleiste (79), die an dem einen Stirnende der Leiterplatte (71) angeordnet ist und deren Steckbuchsen parallel zu der Längserstreckung des Gehäuses (15) ausgerichtet sind, und
mit einer Steckerstiftleiste (77), die an dem anderen Stirnende der Leiterplatte (71) angeordnet ist und deren Steckerstifte (78) parallel zu der Längserstreckung des Gehäuses (15) ausgerichtet sind.

2. Busschiene nach Anspruch 1, **dadurch gekennzeichnet, dass** die Steckbuchsenleiste (79) gegenüber dem Stirnende (24) des Gehäuses (15) nach innen zurückversetzt angeordnet ist.

3. Busschiene nach Anspruch 1, **dadurch gekennzeichnet, dass** das eine Gehäuseteil (16) ein U-förmiges Querschnittsprofil mit zwei zueinander parallelen, voneinander beabstandeten Schenkeln (25), die zumindest Teile der Schmalseiten (22) des Gehäuses (15) bilden, und mit einem sich zwischen den beiden Schenkeln (25) erstreckenden Rückenteil (26), das die Vorderseite (18) des Gehäuses (15) bildet.

4. Busschiene nach Anspruch 1, **dadurch gekennzeichnet, dass** die Vorderseite (18) von zwei parallel im Abstand zueinander verlaufenden Seitenkanten begrenzt ist, an denen Anlageleisten (33,34) angeformt sind, die seitlich über die Schmalseiten (22) überstehen.

5. Busschiene nach Anspruch 4, **dadurch gekennzeichnet, dass** die Schenkel (25) an ihrem von dem Rückenteil (26) abliegenden Ende mit einem im Querschnitt verjüngten leistenförmigen Fortsatz (29) versehen sind.

6. Busschiene nach Anspruch 5, **dadurch gekennzeichnet, dass** das andere Gehäuseteil (17) eine im Wesentlichen ebene Platte ist, die seitlich parallel mit Abstand zueinander verlaufende Nuten (43) zur Aufnahme der leistenförmigen Fortsätze (29) des ersten Gehäuseteils (16) enthält.

7. Busschiene nach Anspruch 1, **dadurch gekennzeichnet, dass** die Rückseite (19) gegenüber den benachbarten Rändern der Schmalseiten (22) des Gehäuses (15) zurückspringt.

8. Busschiene nach Anspruch 1, **dadurch gekennzeichnet, dass** jede an der Vorderseite (18) vorhandene Öffnung (36) von einem Kragen (35) umgrenzt ist.

9. Busschiene nach den Ansprüchen 1 und 4, **dadurch gekennzeichnet, dass** die Schmalseiten (22) des Gehäuses (15) mit Ausnahme der seitlich auskragenden Anlageleisten (33,34) glatt durchgehend sind, derart, dass an der Stoßstelle zwischen dem ersten und dem zweiten Gehäuseteil (16,17) sich ein glatter Übergang ergibt.

10. Busschiene nach Anspruch 1, **dadurch gekennzeichnet, dass** die beiden Stirnenden (23,24) derart gestaltet sind, dass sich bei zwei aneinander gesteckten Busschienen (1) ein weitgehend glatter sprungfreier Übergang von einer Busschiene (1) zu der anderen Busschiene (1) ergibt.

11. Busschiene nach Anspruch 1, **dadurch gekennzeichnet, dass** wenigstens ein Stirnende (23,24) einen im Wesentlichen geschlossenen Schutzkragen (46) aufweist.

12. Busschiene nach Anspruch 11, **dadurch gekennzeichnet, dass** die Steckerstifte (78) nicht über den Schutzkragen (46) vorstehen.

13. Busschiene nach Anspruch 12, **dadurch gekennzeichnet, dass** der Schutzkragen (46) in Richtung parallel zu der Längserstreckung der Busschiene (1) wenigstens zwei Schlitze (48) enthält, die zwischen sich eine als Rastfeder (49) dienende Zunge begrenzen.

14. Busschiene nach Anspruch 1, **dadurch gekennzeichnet, dass** das andere Stirnende (24) in Verlängerung der Schmalseiten (22), der Vorderwand (18) und der Rückwand (19) paarweise zueinander parallele plattenförmige Fortsätze (57,62;63) aufweist, wobei zwischen jeweils einander benachbarten plattenförmigen Fortsätzen (57,62;63) ein Schlitz (66) enthalten ist.

15. Busschiene nach Anspruch 13, **dadurch gekennzeichnet, dass** die Außenseite (59) der plattenförmigen Fortsätze (57, 61) der Vorderwand (18) und der Rückwand (19) gegenüber deren Außenflächen zurückspringen, derart, dass bei zusammengesteckten Busschienen (1) diese plattenartigen Fortsätze (57,61) in den Innenraum eingreifen, der durch den Kragen (46) des anderen Stirnendes (23) gebildet ist.

16. Busschiene nach Anspruch 14, **dadurch gekennzeichnet, dass** der eine Fortsatz (57) eine Rastöffnung (67) enthält.

17. Busschiene nach Anspruch 13, **dadurch gekennzeichnet, dass** die in Verlängerung der Schmalseiten (22) vorhandenen plattenförmigen Fortsätze (63) derart gestaltet sind, dass sie bei zusammengesteckten Busschienen (1) sich an der Außenseite des Kragens (46) an dem anderen Stirnende (23) anlegen.

18. Busschiene nach Anspruch 1, **dadurch gekennzeichnet, dass** die Breite des Gehäuses (15), gemessen über die Außenfläche der Schmalseiten (22), nicht größer als die lichte Weite der Nut (9) in einer Normhutschiene (2) ist.

19. Busschiene nach Anspruch 1, **dadurch gekennzeichnet, dass** die Tiefe des Gehäuses (15), gemessen senkrecht zu dessen Vorderseite (18), nicht größer als die Tiefe der Nut (9) in einer Normhutschiene (2) ist.

20. Busschiene nach Anspruch 1, **dadurch gekennzeichnet, dass** das zweite Gehäuseteil (16) und das erste Gehäuseteil (15) im Bereich ihrer Trennfuge Verriegelungsglieder (45) enthalten, derart, dass die beiden Gehäuseteile (16,17) in Längsrichtung nicht gegeneinander verschiebbar sind.

21. Busschiene nach Anspruch 1, **dadurch gekennzeichnet, dass** ihr wenigstens eine Halteklammer (81) zugeordnet ist, um die Busschiene (1) in einer Normhutschiene (2) festzusetzen.

22. Busschiene nach Anspruch 21, **dadurch gekennzeichnet, dass** die Halteklammer (81) aus einem Rückenteil (82) und zwei parallel mit Abstand voneinander verlaufenden und von dem Rückenteil (82) wegstehenden seitlichen Federschenkeln (85,86) gebildet ist.

23. Busschiene nach Anspruch 21, **dadurch gekennzeichnet, dass** die Halteklammer (81) bzw. das Gehäuse (15) mit Mitteln (35,87) versehen sind, um die Halteklammer (81) bezüglich des Gehäuses (15) in der Längsrichtung des Gehäuses (15) festzulegen.

24. Busschiene nach Anspruch 23, **dadurch gekennzeichnet, dass** die Mittel zum Festlegen der Halteklammer (81) an dem Gehäuse (15) von einem der Krägen (35) an der Vorderseite (18) und einer Öffnung (87) in dem Rücken (82) der Halteklammer (81) gebildet ist, derart, dass die Halteklammer (81) über den Kragen (35) steckbar ist.

25. Busschiene nach Anspruch 21, **dadurch gekennzeichnet, dass** die Halteklammer (81) mit der Leiterplatte (71) elektrisch leitend verbunden ist.

## Claims

1. Modular bus bar (1)
with an elongated housing (15) having a front side (18) containing openings (36), a rear side (19) parallel thereto, two narrow sides (22) and two open front ends (23, 24), said housing defining a tubular interior and having a first and a second elongated housing part (16, 17) belonging to it, which are interconnected, wherein the front ends (23, 24) are configured to be complementary to one another in such a way that to each front end (23, 24) the complementary front end (23, 24) of a modular bus bar (2) of the same configuration may be attached,
with an elongated printed circuit board (71) disposed in the interior with printed circuit boards (72) arranged thereon, which have two flat sides as well as two front ends and their width is dimensioned so that it may be accommodated in the elongated interior,
with connector strips (73), which are disposed on one flat side of the printed circuit board (71), are connected to the printed circuit boards (72) to be electrically conductive and each of which is flush with an associated opening (36) in the front side (18) of the housing (15), with a socket connector strip (79), which is disposed at one front end of the printed circuit board (71) and the sockets of which are oriented parallel to the longitudinal extension of the housing (15),
with a connector pin strip (77), which is disposed at the other front end of the printed circuit board (71) and the connector pins (78) of which are oriented parallel to the longitudinal extension of the housing (15).

2. Bus bar according to Claim 1, **characterised in that** the socket connector strip (79) is disposed to be set back towards the inside in relation to the front end (24) of the housing (15).

3. Bus bar according to Claim 1, **characterised in that** one housing part (16) forms a U-shaped cross-sectional profile with two parallel spaced legs (25), which form at least parts of the narrow sides (22) of the housing (15), and with a rear part (26) extending between the two legs (25), which forms the front side (18) of the housing (15).

4. Bus bar according to Claim 1, **characterised in that** the front side (18) is bound by two side edges running parallel at a distance from one another, on which abutment strips (33, 34) are formed, which project laterally over the narrow sides (22).

5. Bus bar according to Claim 4, **characterised in that** the legs (25) are provided at their end remote from the rear part (26) with a strip-like continuation (29) having a tapering cross-section.

6. Bus bar according to Claim 5, **characterised in that** the other housing part (17) is an essentially plane plate, which contains grooves (43) extending laterally parallel and at a distance from one another to house the strip-like continuations (29) of the first housing part (16).

7. Bus bar according to Claim 1, **characterised in that** the rear side (19) recedes in relation to the adjacent edges of the narrow sides (22) of the housing (15).

8. Bus bar according to Claim 1, **characterised in that** each opening (36) arranged on the front side (18) is surrounded by a collar (35).

9. Bus bar according to Claims 1 and 4, **characterised in that** the narrow sides (22) of the housing (15), with the exception of the laterally projecting abutment strips (33, 34), are smoothly continuous such that a smooth transition results at the joint between the first and the second housing part (16, 17).

10. Bus bar according to Claim 1, **characterised in that** the structure of the two front ends (23, 24) is such that in the case of two bus bars (1) being plugged into one another, a substantially smooth step-free transition from one bus bar (1) to another bus bar (1) results.

11. Bus bar according to Claim 1, **characterised in that** at least one front end (23, 24) has an essentially closed protective collar (46).

12. Bus bar according to Claim 11, **characterised in that** the connector pins (78) do not project beyond the protective collar (46).

13. Bus bar according to Claim 12, **characterised in that** in the direction parallel to the longitudinal extension of the bus bar (1), the protective collar (46) contains at least two slots (48), which between them define a tongue serving as catch spring (49).

14. Bus bar according to Claim 1, **characterised in that** as an extension of the narrow sides (22), the front wall (18) and the rear wall (19), the other front end (24) has plate-type continuations (57, 62; 63) parallel to one another in pairs, a slot (66) being contained between respectively adjacent plate-type continuations (57, 62; 63).

15. Bus bar according to Claim 13, **characterised in that** the outside (59) of the plate-type continuations (57, 61) of the front wall (18) and the rear wall (19) recedes in relation to the outer surfaces thereof such that, when bus bars (1) are plugged together, these plate-type continuations (57, 61) engage into the interior formed by the collar (46) of the other front end (23).

16. Bus bar according to Claim 14, **characterised in that** one continuation (57) contains a catch opening (67).

17. Bus bar according to Claim 13, **characterised in that** the plate-shaped continuations (63) arranged as extension of the narrow sides (22) are configured such that they abut against the outside of the collar (46) on the other front end (23), when bus bars (1) are plugged together.

18. Bus bar according to Claim 1, **characterised in that** the width of the housing (15), measured over the outer surface of the narrow sides (22), is not greater than the width of the groove (9) in a standard top hat rail (2).

19. Bus bar according to Claim 1, **characterised in that** the depth of the housing (15), measured perpendicular to the its front side (18), is not greater than the depth of the groove (9) in a standard top hat rail (2).

20. Bus bar according to Claim 1, **characterised in that** the second housing part (16) and the first housing part (15) contain locking members (45) in the region of their parting line so that the two housing parts (16, 17) are not displaceable relative to one another in longitudinal direction.

21. Bus bar according to Claim 1, **characterised in that** it is assigned at least one holding clip (81) in order to secure the bus bar (1) in a standard top hat rail (2).

22. Bus bar according to Claim 21, **characterised in that** the holding clip (81) is formed from a rear portion (82) and two lateral spring legs (85, 86) running parallel at a distance from one another and projecting away from the rear portion (82).

23. Bus bar according to Claim 21, **characterised in that** the holding clip (81) or the housing (15) is provided with means (35, 87) in order to fix the holding clip (81) relative to the housing (15) in the longitudinal direction of the housing (15).

24. Bus bar according to Claim 21, **characterised in that** the means for fixing the holding clip (81) on the housing (15) is formed by one of the collars (35) on the front side (18) and an opening (87) in the rear (82) of the holding clip (81) such that the holding clip (81) may be clipped over the collar (35).

25. Bus bar according to Claim 21, **characterised in that** the holding clip (81) is connected to the printed circuit board (71) to be electrically conductive.

## Revendications

1. Barres de bus (1) juxtaposbales
avec un boîtier (15) allongé, qui comporte une face antérieure (18) avec des ouvertures (36), une face postérieure (19) parallèle à celle-ci, deux petits côtés (22) ainsi que deux faces frontales (23, 24) ouvertes, définit une chambre intérieure en forme de tube et auquel appartiennent une première et une deuxième parties de boîtier (16, 17) allongées, liées l'une à l'autre, les faces frontales (23, 24) étant mutuellement complémentaires, de telle sorte qu'à chaque extrémité frontale (23, 24) puisse être enfichée l'extrémité frontale (23, 24) complémentaire d'une barre de bus (2) juxtaposable ayant la même conformation,
avec une carte à circuit imprimé (71) allongée avec des pistes conductrices (72) prévues sur celle-ci, qui est disposée dans la chambre intérieure, présente deux faces planes ainsi que deux extrémités frontales, et dont la largeur est telle qu'elle puisse être logée dans la chambre intérieure allongée,
avec des barrettes (73) de connecteurs enfichables qui sont disposées sur une face plane de la carte à circuit imprimé (71), sont reliées de manière électro-conductrice auxdites pistes conductrices (72) et sont disposées chacune dans l'alignement d'une ouverture associée (36) dans la face antérieure (18) du boîtier (15),
avec une barrette (79) de connecteurs femelles qui est disposée sur l'une des faces frontales de la carte à circuit imprimé (71), et dont les douilles de connecteurs sont orientées parallèlement à la direction longitudinale du boîtier (15), et
avec une barrette (77) de connecteurs mâles qui est disposée sur l'autre face frontale de la carte à circuit imprimé (71), et dont les fiches de connecteurs sont orientées parallèlement à la direction longitudinale du boîtier (15).

2. Barre de bus selon la revendication 1, **caractérisée en ce que** la barrette (79) de connecteurs femelles est disposée en retrait vers l'intérieur par rapport à l'extrémité frontale (24) du boîtier (15).

3. Barre de bus selon la revendication 1, **caractérisée en ce que** l'une des parties de boîtier (16) a, en section transversale, un profil en forme de U, avec deux ailes (25) mutuellement parallèles, espacées l'une de l'autre, qui forment au moins des parties des petits côtés (22) du boîtier (15), et avec une partie dos (26), qui s'étend entre les deux ailes (25) et forme la face antérieure (18) du boîtier (15).

4. Barre de bus selon la revendication 1, **caractérisée en ce que** la face antérieure (18) est délimitée par deux bords latéraux parallèles espacés l'un de l'autre sur lesquels sont formés des rebords d'appui (33, 34) qui débordent latéralement par rapport aux petits côtés (22).

5. Barre de bus selon la revendication 4, **caractérisée en ce que** les ailes (25), à leur extrémité éloignée de la partie dos (26), sont pourvues d'une prolongement (29) en forme de barrette, de section transversale réduite.

6. Barre de bus selon la revendication 5, **caractérisée en ce que** l'autre partie de boîtier (17) est une plaque essentiellement plane, qui comporte, sur les côtés, des rainures (43) parallèles, espacées l'une de l'autre, pour recevoir les prolongements (29) en forme de barrette de la première partie de boîtier (16).

7. Barre de bus selon la revendication 1, **caractérisée en ce que** la face postérieure (19) est en retrait par rapport aux bords voisins des petits côtés (22) du boîtier (15).

8. Barre de bus selon la revendication 1, **caractérisée en ce que** chaque ouverture (36) dans la face antérieure (18) est entourée d'un collet (35).

9. Barre de bus selon les revendications 1 et 4, **caractérisée en ce que** les petits côtés (22) du boîtier (15), à l'exception des rebords d'appui (33, 34), latéralement en porte-à-faux, sont entièrement lisses, de sorte que le raccordement au niveau du joint entre les première et deuxième parties de boîtier est lisse.

10. Barre de bus selon la revendication 1, **caractérisée en ce que** les deux extrémités frontales (23, 24) sont conformées de telle sorte que lorsque deux barres de bus (1) sont connectées l'une à l'autre, le raccordement d'une barre de bus (1) à l'autre barre de bus (1) soit essentiellement lisse, sans ressaut.

11. Barre de bus selon la revendication 1, **caractérisée en ce qu'**au moins une face frontale (23, 24) présente un collet de protection (46) essentiellement fermé.

12. Barre de bus selon la revendication 11, **caractérisée en ce que** les fiches de connecteur (78) ne dépassent pas par rapport au collet de protection (46).

13. Barre de bus selon la revendication 12, **caractérisée en ce que** le collet de protection (46), dans la direction parallèle à la longueur de la barre de bus (1), comporte au moins deux fentes (48), qui définissent entre elles une languette formant ressort d'encliquetage (49).

14. Barre de bus selon la revendication 1, **caractérisée en ce que** l'autre extrémité frontale (24), dans la continuité des petits côtés (22), de la paroi antérieure (18) et de la paroi postérieure (19), présente des prolongements (57, 62 ; 63) en forme de plaquettes parallèles deux à deux, une fente (66) étant présente chaque fois entre des prolongements (57, 62 ; 63) en forme de plaquettes consécutifs.

15. Barre de bus selon la revendication 13, **caractérisée en ce que** la face extérieure (59) des prolongements (57, 61) en forme de plaquettes de la paroi antérieure (18) et de la paroi postérieure (19) est en retrait par rapport à la face extérieure desdites parois, de telle sorte que, lorsque les barres de bus (1) sont enfichées, lesdits prolongements (57, 61) en forme de plaquettes s'engagent dans la chambre intérieure définie par le collet (46) de l'autre extrémité frontale (23).

16. Barre de bus selon la revendication 14, **caractérisée en ce que** l'un des prolongements (57) comporte une ouverture d'encliquetage (67).

17. Barre de bus selon la revendication 13, **caractérisée en ce que** les prolongements (63) en forme de plaquettes prévus dans la continuité des petits côtés (22) sont conformés de telle sorte que, lorsque les barres de bus (1) sont enfichées, ils soient appliqués sur la face extérieure du collet (46) sur l'autre extrémité frontale (23).

18. Barre de bus selon la revendication 1, **caractérisée en ce que** la largeur du boîtier (15) mesurée au niveau de la surface extérieure des petits côtés (22) n'est pas supérieure à la largeur libre de la rainure (9) dans un rail de type oméga (2) normalisé.

19. Barre de bus selon la revendication 1, **caractérisée en ce que** la profondeur du boîtier (15), mesurée perpendiculairement à la face antérieure (18) de celui-ci, n'est pas supérieure à la profondeur de la rainure (9) dans un rail de type oméga (2) normalisé.

20. Barre de bus selon la revendication 1, **caractérisée en ce que** la deuxième partie de boîtier (16) et la première partie de boîtier (15), dans la région de leur joint de séparation, comportent des organes de verrouillage (45) tels, que les deux parties de boîtier (16, 17) ne puissent pas se déplacer l'une par rapport à l'autre dans la direction longitudinale.

21. Barre de bus selon la revendication 1, **caractérisée en ce qu'**il lui est associé au moins une agrafe de retenue (81), aux fins de tenir la barre de bus (1) dans un rail de type oméga (2) normalisé.

22. Barre de bus selon la revendication 21, **caractérisée en ce que** l'agrafe (81) est formée d'une partie dos (82) et de deux ailes (85, 86) latérales, élastiques parallèles, espacées l'une de l'autre, qui s'étendent à partir de la partir dos (82).

23. Barre de bus selon la revendication 21, **caractérisée en ce que** l'agrafe (81) ou le boîtier (15) est muni de moyens (35, 87) pour assujettir l'agrafe de retenue (81) par rapport au boîtier (15), dans la direction longitudinale dudit boîtier (15).

24. Barre de bus selon la revendication 23, **caractérisée en ce que** les moyens pour assujettir l'agrafe de retenue (81) par rapport au boîtier (15) sont formés par l'un des collets (35) sur la face antérieure (18) et une ouverture (87) dans le dos (82) de l'agrafe de retenue (81), de telle sorte que l'agrafe de retenue (81) peut être enfilée sur le collet (35).

25. Barre de bus selon la revendication 21, **caractérisée en ce que** l'agrafe de retenue (81) est reliée électriquement à la carte à circuit imprimé (71).
